# EUROPEAN PATENT SPECIFICATION

(11) **EP 1 521 376 B1**
(45) Date of publication and mention of the grant of the patent: **22.03.2006**
(21) Application number: 03022321.8
(22) Date of filing: 04.10.2003
(51) Int. Cl.: H04B 1/04, H03F 3/21, H03F 1/02

(54) **Base station for a wireless telecommunications system**
Basisstation für ein Funktelekommunikationssystem
Station de base pour une système de télécommunication sans fil

(43) Date of publication of application: 06.04.2005
(73) Proprietor: Lucent Technologies Network Systems GmbH, 90411 Nürnberg (DE)
(72) Inventor: Eckl, Wolfgang Franz, Dr., 91080 Spardorf (DE); Fischer, Georg, Dr., 90419 Nürnberg (DE); Friedel, Bernd Georg, 91477 Markt Bibart (DE)
(74) Representative: Blumbach - Zinngrebe

(56) References cited:
- US-A- 5 872 481
- US-B1- 6 615 028

## Description

### Specification

### Field of the Invention

The invention relates to a base station for a wireless telecommunications system in general, and to a base station and amplifier arrangement for a CDMA system or network in particular.

### Background of the Invention

Building up CDMA (code division multiple access) wireless communication systems, e.g. realised as the UMTS (universal mobile telecommunications system) standard is a major challenge for telecommunication industry. (The term CDMA reflects, among others, e.g. UMTS/W-CDMA/3GPP or CDMA2000/3G1x/3GPP2).

With a CDMA basestation its amplifier has to be designed for the maximum transmit power needed. However, the maximum power is needed very seldom during operation. This implies that the amplifier most of the time is operated with reduced power.

This reduction in power is often called back-off. One basic problem is that the efficiency gets pretty worse in back-off mode.

Efficiency is understood here as the ratio in terms of RF power versus supply power. Anyhow with CDMA like modulations, efficiency is very bad at maximum transmit power. Typically numbers are around 5 to 10%. In back-off mode those efficiency numbers get even worse.

The amplifiers consume the dominant fraction of power taken from mains. 10% efficiency for instance means that 10% of the power taken from mains is converted to RF power, but 90% of the power from mains is simply converted to useless heat. Now as efficiency is bad, the basestations consume too much power. But power consumption is one big contributor to the operational costs for a network operator. Improving efficiency directly maps to reduced operational costs for energy.

Besides the cost savings for operators there is also an ecological effect. Compliance to ecological roadmaps and ecological certifications like ISO 14001 and the energy consumption of a network should be reduced.

From US Patent 5,872,481 a parallel-stage power amplifier is known. This amplifier is designed for use in portable units, to address the following problem. If the signal transmitted by the portable unit arrives at the cell-site receiver at a power level that is too low, the bit-error rate may be too high. If, on the other hand, the power level of the signal transmitted by the portable unit is too high when received at the cell-site receiver, interference will occur with other mobile unit transmitted signals. Furthermore, battery power of the portable unit should be saved.

Therefore, a power amplifier is provided having four parallel amplifier stages to regulate the transmit power. For the regulation the signals received from each portable unit at the cell-site station are measured, and the measurement results compared with a desired power level. Then, a switch logic monitors the level of the amplified RF signal at an output node, and instructs an input and an output network to select the amplifier stages to provide output power over a range in which is included the monitored signal level or the switch logic monitors a received power level or power control commands from an associated base station.

From US Patent 6,615,028 a system and method for selecting amplifiers in a communications device is known. The patent start from the desire to have an operating time, particularly a talk time, which is as long as possible. Therefore, different operational ranges are provided. However, the procedure compares the determined output power with the power range of the currently active power amplifier.

However, none of the afore-cited documents addresses or provides an improvement regarding the back-off operation of a base station.

### Summary of the Invention

Therefore, it is an object of the present invention to provide a base station and amplifier arrangement for a base station with high efficiency and/or low power consumption.

A further object of the invention is to provide a base station and amplifier arrangement which can be flexibly adapted to fluctuations in RF transmission power requested.

Still a further object of the invention is to provide a base station and amplifier arrangement which avoid or at least ameliorate disadvantages of prior art systems.

The object of the invention is achieved in a surprisingly simple manner by subject matter of the independent claims.

According to the invention a base station, preferably a CDMA base station for a wireless telecommunications system or network is provided, comprising:
an amplifier arrangement for amplifying signals transmitted by the base station, wherein
said amplifier arrangement comprises two or more parallel amplifier branches.

According to a preferred embodiment at least some, preferably all, amplifier branches have unequal values of maximum output or RF power and/or different thresholds to be switched on.

Unequally partitioned RF power and switching on and off certain amplifier branches does not only achieve efficiency improvements, but is also advantageous in the context of CDMA systems compared to implementing parallel amplifiers with equally partitioned RF power.

Implementing parallel amplifier branches each having unequal RF power capability matches much better the statistics of varying transmit power with CDMA system than with equal RF power. Furthermore, according to the invention, the partitioning of RF power and selection of actual RF power amplifier size is well adapted depending on to the power statistics of CDMA systems.

Further preferred embodiments of the invention are subject of the subclaims.

According to a preferred embodiment of the invention a base station is provided, wherein said amplifier arrangement comprises at least:
a first amplifier branch with a maximum output power of < 30%, preferably < 20% of the total maximum output power of said amplifier arrangement,
a second amplifier branch with a maximum output power of 10% to 50%, preferably 20% to 40% of the total maximum output power of said amplifier arrangement and
a third amplifier branch with a maximum output power of > 30%, preferably > 50% of the total maximum output power of said amplifier arrangement.

According to a preferred embodiment of the invention a base is provided, wherein said power thresholds are different for at least some, preferably all, of said amplifier branches and/or said amplifier branches are subsequently switched on with increasing power requested.

According to a further preferred embodiment of the invention a base is provided, wherein, preferably only, said first amplifier branch is switched on for a pilot channel, when no or low traffic is existing and/or said second amplifier branch is switched on when the traffic is increasing and/or said third amplifier branch is switched on when the traffic is further increasing.

Furthermore, the amplifier arrangement itself, being adapted for a base station, preferably for a CDMA base station for a wireless telecommunications system or network comprising two or more parallel amplifier branches lies within the scope of the invention.

Moreover, a method of operating a base station is proposed, wherein
an amplifier arrangement with at least a first, second and third amplifier branch is provided,
said first amplifier branch has a lower maximum output power level than said second amplifier branch and said second amplifier branch has a lower maximum output power level than said third amplifier branch,
said first amplifier branch is switched on, when a pilot channel is present,
said second amplifier branch is switched on by a controller, when a power raise compared to the power of the pilot channel of between 1 dB and 9 dB, preferably between 2 dB and 8 dB, preferably between 3 dB and 7 dB, preferably between 4 dB and 6 dB is present and
said third amplifier is switched on by said controller, when a power raise compared to the power of the pilot channel of at least 6 dB, preferably at least 7 dB, preferably at least 8 dB, preferably at least 9 dB, preferably about 10 dB is present.

The invention is described in more detail and in view of preferred embodiments hereinafter. Reference is made to the attached drawings.

### Brief Description of the Figures

It is shown in:
Fig. 1 the power raise and back-off for typical operating conditions of a CDMA base station,
Fig. 2 a graph of the power raise and back-off as a function of traffic load and
Fig. 3 a schematic diagram of an amplifier arrangement with three amplifier branches with unequally partitioned power.

### Detailed Description of the Invention

The invention provides an optimized partitioning of RF power with a scalable parallel amplifier arrangement 10.

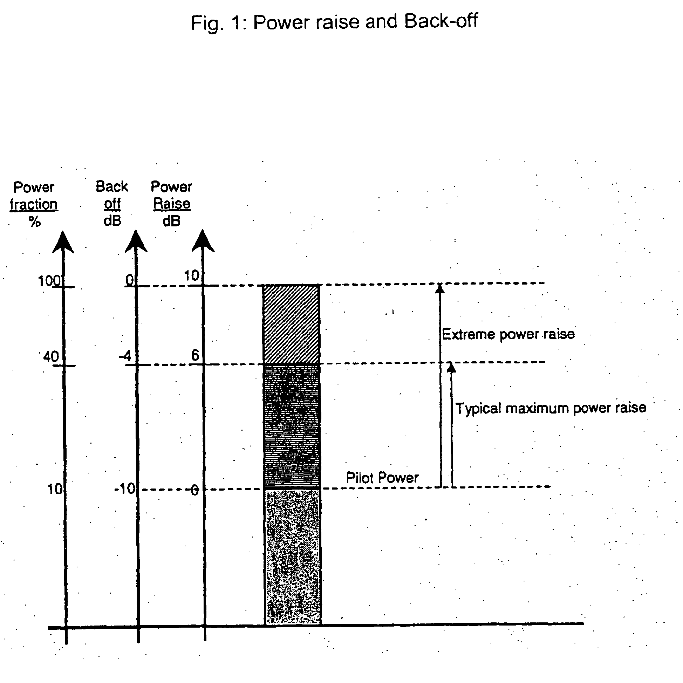

With CDMA systems the pilot channel is present all time. Typically it is adjusted to be transmitted with 10% of maximum power available from the amplifier. In other words this means that a back-off in the order of 10 dB is applied with the pilot channel. With more and more users in the system more and more codes get used with each code taking additional RF power. Consequently, with increasing traffic the power of the basestation raises while the pilot power is untouched (Fig. 1).

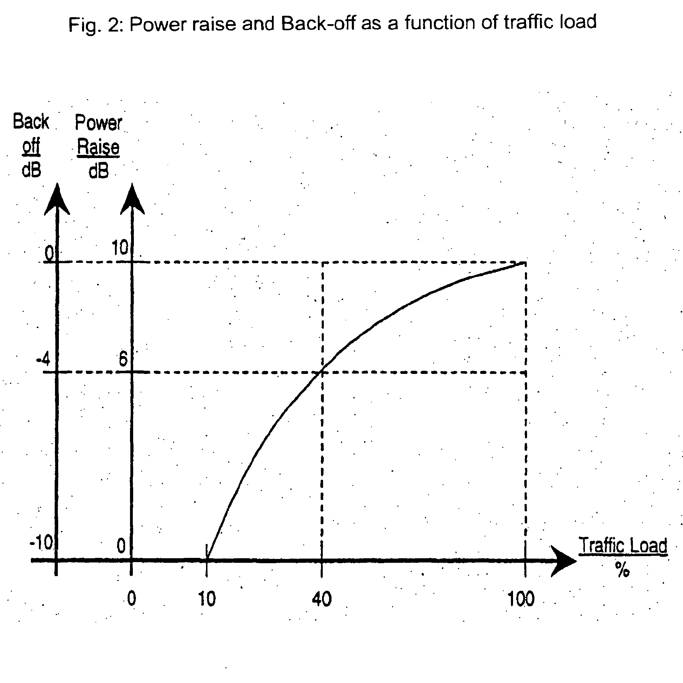

Now one can imagine that during night traffic is very low. Looking at Fig. 2 (a typical characteristic, depends on a lot of parameters) it can be seen, that below 10% of maximum traffic the power raise can more or less be neglected. Looking at traffic load curves measured in field experiments it can be seen that from midnight to very early in the morning there is nearly no traffic. So roughly 1/3rd of the day the basestation is operating at 10 dB back-off. Preferably, this reflects the first point a parallel amplifier structure should be optimized for.

There is a further threshold, which is around 6 dB power raise. Typically load control algorithms in a CDMA system try to keep power raise below 6 dB by adjusting power control and usable data rates. As a rough order of magnitude 99% of the time the power raise is below 6 dB or in other words the power amplifier is operated with more than 4 dB back-off.

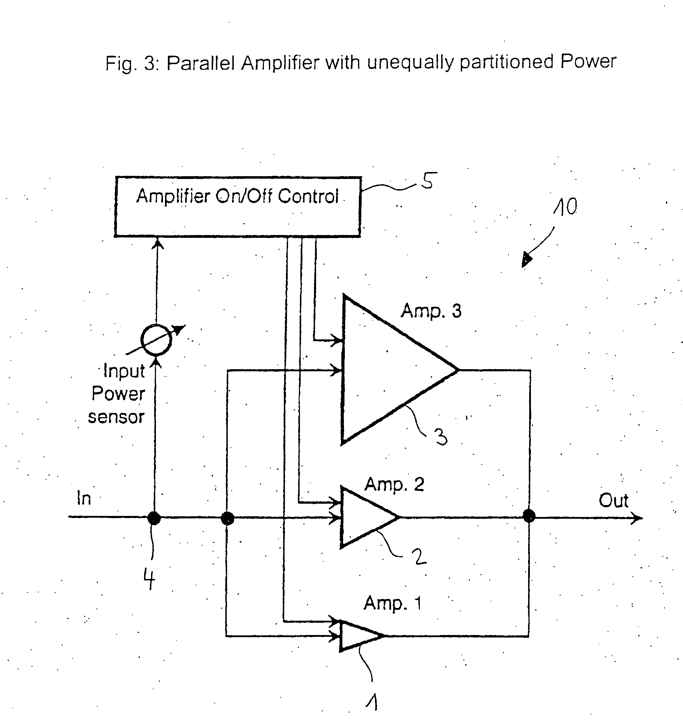

Only very seldom under extreme conditions and only for a very short period of time power raise might get to 10 dB implying 0 dB back-off or full power from the amplifier. These cases roughly only occur 1 % of the time. Consequently this means that in a parallel amplifier design comprising three amplifier branches each comprising or consisting of one amplifier (Amp. 1-3) according to Fig. 3, that the power of Amplifier 1 and Amplifier 2. together is 4 dB lower than the power available from all 3 amplifiers together. Only for extreme cases, which may occur only 1 % of the time, amplifier 3 is switched on.

Switching on and off the amplifier branches is performed by a control instance or controller 5 as depicted in Fig. 3. This control instance 5 needs to know what power actually is requested from the amplifier. This information may be sensed by looking at or determining the power at the input 4 of the amplifier, which is a more generous approach, or by being linked to other control instances inside the basestation.

The following table 1 is illustrating the operating conditions of the parallel amplifier.

**Table 1:**

| | Amplifier 1 | Amplifier 2 | Amplifier 3 |
|---|---|---|---|
| Designed for x fraction of power | 10% | 30% | 60% |
| Switched on for pilot and zero to low traffic (power raise <1 dB) | yes | no | no |
| Switched on for normal traffic conditions (power raise < 6 dB) | yes | yes | no |
| Switched on for extreme conditions | yes | yes | yes |

The base station advantageously provides an efficiency of > 5%, preferably > 10%, when operated with a power reduction of > 50% or > 90%.

The invention can be further extended. If a CDF (Cumulative distribution function) of output power is known, then sensible thresholds can be set and a split into more parallel amplifier branches can be done, however the basic idea keeps the same.

A split into a great number of parallel paths would be desirable, however this suffers from implementation problems. It appears that the number of parallel amplifier path should be restricted to 4 or 5, as the gains in reducing power consumption become so low after this point that they likely do not justify the higher complexity. A split into 3 branches as shown above already delivers most of the savings.

One of the key issues is that a power amplifier gets scalable to avoid great back-off operation. The fractions of power available from the parallel amplifier branches have to be set in a sensible manner so that the discrete steps in power match typical operation conditions.

The invention is advantageous as it enhances the average efficiency a power amplifier is running at. So far people mainly focused on efficiency enhancements for power amplifiers running at maximum power. But what's even more important is that in real field operation, where there is power control and varying traffic load also the efficiency is good. Thus it is a key issue also to enhance efficiency for back-off operation.

Network operators have to pay a lot of money for energy consumption with CDMA systems, as the power amplifiers run so bad efficiency. By the invention power consumption is significantly reduced, leading to less operational costs. The costs for implementing the invention are fairly low, as typical every amplifier comprises parallel branches. It is just the question, how those parallel branches are partitioned and whether there is a means to switch on and off individual branches.

Particularly, the approach to utilise an asymmetric parallel amplifier design is believed to be novel. In the context of a CDMA system it is advantageous to make at least some of the amplifier branches of different size.

What's achieved is that the power amplifier structure is adapted to the statistics of RF power transmitted. Fractions of the power amplifier are switched on and off allowing to track RF power fluctuations due to varying traffic load and varying power control.

One of the key issues of the invention is the match between often-occurring operation conditions and power fractions available from a scalable parallel amplifier arrangement 10.

It will be appreciated that the above-described embodiments of the invention have been set forth solely by way of example and illustration of the principles thereof.

## Claims

1. Base station for a wireless telecommunications system or network comprising:
an amplifier arrangement (10) for amplifying signals transmitted by the base station, wherein
said amplifier arrangement (10) comprises two or more parallel amplifier branches, wherein a first amplifier branch (1) is switched on for a pilot channel, when no or low traffic is existing and whereby a second amplifier branch (2) is switched on when the traffic is increasing.

2. Base station according to claim 1, wherein at least some, preferably all, amplifier branches (1, 2, 3) provide a different maximum output power.

3. Base station according to one of the preceding claims, comprising an amplifier controller (5) controlling said amplifier branches (1, 2, 3) and/or to separately switch on and/or off said amplifier branches (1, 2, 3).

4. Base station according to one of the preceding claim 3, wherein said amplifier controller (5) switches on and/or off said amplifier branches (1, 2, 3) in response to the RF transmission power of said amplifier arrangement (10).

5. Base station according to claim 3 or 4, comprising an input power sensor determining the input power at a common input of said amplifier branches and transmitting said input power to said amplifier controller (5), wherein said amplifier controller (5) controls said amplifier branches (1, 2, 3) in response to said input power.

6. Base station according to one of claims 3 to 5, wherein for each amplifier branch (1, 2, 3) a predetermined power threshold is defined and wherein said amplifier branches (1, 2, 3) are switched on by the amplifier controller (5) when the power threshold associated with the respective amplifier branch (1, 2, 3) is exceeded.

7. Base station according to one of the preceding claims, wherein each of said amplifier branches (1, 2, 3) comprises one amplifier or consists of one amplifier and/or the maximum output power of said amplifier branches (1, 2, 3) or amplifiers is essentially logarithmically scaled with respect to each other.

8. Base station according to one of the preceding claims, wherein said amplifier arrangement (10) comprises at least:
a first amplifier branch (1) with a maximum output power of < 30% of the total maximum output power of said amplifier arrangement (10),
a second amplifier branch (2) with a maximum output power of 10% to 50% of the total maximum output power of said amplifier arrangement (10) and
a third amplifier branch (3) with a maximum output power of > 30% of the total maximum output power of said amplifier arrangement (10).

9. Base station according to one of claims 6 to 8, wherein the power thresholds are different for at least some of said amplifier branches (1, 2, 3) and/or said amplifier branches (1, 2, 3) are subsequently switched on with increasing power.

10. Base station according to one of the preceding claims, wherein a third amplifier branch (3) is switched on when the traffic is further increasing.

11. Amplifier arrangement (10), adapted for a base station for a wireless telecommunications system or network according to one of the preceding claims, comprising two or more parallel amplifier branches (1, 2, 3).

12. Method of operating a base station, wherein an amplifier arrangement (10) with at least a first, second and third amplifier branch (1, 2, 3) is provided,
said first amplifier branch (1) has a lower maximum output power level than said second amplifier branch (2) and said second amplifier branch (2) has a lower maximum output power level than said third amplifier branch (3),
said first amplifier branch (1) is switched on, when a pilot channel is present,
said second amplifier branch (2) is switched on by a controller (5), when a power raise compared to the power of the pilot channel of between 1 dB and 9 dB_is present and
said third amplifier (3) is switched on by said controller (5), when a power raise compared to the power of the pilot channel of at least 6 dB is present.

13. Method according to claim 12, comprising the steps of:
determining a cumulative distribution function of output power for the base station,
setting a different threshold for each of said amplifier branches (1, 2, 3) dependent on different values of traffic load in said cumulative distribution function.

## Patentansprüche

1. Basisstation für ein drahtloses Telekommunikationssystem oder Netzwerk, umfassend:
eine Verstärkeranordnung (10) zum Verstärken von Signalen, die von der Basisstation gesendet werden, wobei
die Verstärkeranordnung (10) zwei oder mehr parallele Verstärkerzweige umfasst, wobei ein erster Verstärkerzweig (1) für einen Pilotkanal angeschaltet ist, wenn kein oder wenig Verkehr vorhanden ist, und wobei ein zweiter Verstärkerzweig (2) angeschaltet wird, wenn sich der Verkehr erhöht.

2. Basisstation nach Anspruch 1,
wobei zumindest einige, vorzugsweise alle, Verstärkerzweige (1, 2, 3) eine unterschiedliche maximale Ausgangsleistung bereitstellen.

3. Basisstation nach einem der vorhergehenden Ansprüche, welche einen Verstärker-Controller (5) umfasst, der die Verstärkerzweige (1, 2, 3) steuert und/oder die Verstärkerzweige (1, 2, 3) separat anschaltet und/oder abschaltet.

4. Basisstation nach Anspruch 3,
wobei der Verstärker-Controller (5) die Verstärkerzweige (1, 2, 3) in Ansprechen auf die RF-Sendeleistung der Verstärkeranordnung (10) anschaltet und/oder abschaltet.

5. Basisstation nach Anspruch 3 oder 4,
welche einen Sensor für die Eingangsleistung umfasst, der die Eingangsleistung an einem gemeinsamen Eingang der Verstärkerzweige bestimmt und die Eingangsleistung an den Verstärker-Controller (5) überträgt, wobei der Verstärker-Controller (5) die Verstärkerzweige (1, 2, 3) in Ansprechen auf diese Eingangsleistung steuert.

6. Basisstation nach einem der Ansprüche 3 bis 5,
wobei für jeden Verstärkerzweig (1, 2, 3) ein vorgegebener Leistungsschwellwert definiert ist, und wobei die Verstärkerzweige (1, 2, 3) durch den Verstärker-Controller (5) angeschaltet werden, wenn der dem jeweiligen Verstärkerzweig (1, 2, 3) zugeordnete Schwellwert überschritten wird.

7. Basisstation nach einem der vorhergehenden Ansprüche,
wobei jeder der Verstärkerzweige (1, 2, 3) einen Verstärker umfasst oder aus einem Verstärker besteht und/oder wobei die maximale Ausgangsleistung der Verstärkerzweige (1, 2, 3) oder Verstärker in Bezug aufeinander im Wesentlichen logarithmisch skaliert ist.

8. Basisstation nach einem der vorhergehenden Ansprüche, wobei die Verstärkeranordnung (10) zumindest umfasst:
einen ersten Verstärkerzweig (1) mit einer maximalen Ausgangsleistung von < 30 % der maximalen Gesamtausgangsleistung der Verstärkeranordnung (10),
einen zweiten Verstärkerzweig (2) mit einer maximalen Ausgangsleistung von 10 % bis 50 % der maximalen Gesamtausgangsleistung der Verstärkeranordnung (10) und
einen dritten Verstärkerzweig (3) mit einer maximalen Ausgangsleistung von > 30 % der maximalen Gesamtausgangsleistung der Verstärkeranordnung (10).

9. Basisstation nach einem der Ansprüche 6 bis 8,
wobei die Leistungsschwellwerte für zumindest einige der Verstärkerzweige (1, 2, 3) unterschiedlich sind und/oder wobei die Verstärkerzweige (1, 2, 3) nacheinander mit zunehmender Leistung angeschaltet werden.

10. Basisstation nach einem der vorhergehenden Ansprüche,
wobei ein dritter Verstärkerzweig (3) angeschaltet wird, wenn der Verkehr weiter zunimmt.

11. Verstärkeranordnung (10), die für eine Basisstation für ein drahtloses Telekommunikationssystem oder Netzwerk entsprechend einem der vorhergehenden Ansprüche ausgebildet ist, welche zwei oder mehr parallele Verstärkerzweige (1, 2, 3) umfasst.

12. Verfahren zum Betreiben einer Basisstation, wobei
eine Verstärkeranordnung (10) mit zumindest einem ersten, zweiten und dritten Verstärkerzweig (1, 2, 3) bereitgestellt wird,
wobei der erste Verstärkerzweig (1) einen niedrigeren maximalen Ausgangsleistungspegel als der zweite Verstärkerzweig (2) aufweist und der zweite Verstärkerzweig (2) einen niedrigeren maximalen Ausgangsleistungspegel als der dritte Verstärkerzweig (3) aufweist,
wobei der erste Verstärkerzweig (1) angeschaltet wird, wenn ein Pilotkanal vorhanden ist,
der zweite Verstärkerzweig (2) durch einen Controller (5) angeschaltet wird, wenn ein Leistungsanstieg zwischen 1 dB und 9 dB im Vergleich zu der Leistung des Pilotkanals vorhanden ist, und
der dritte Verstärker (3) durch den Controller (5) angeschaltet wird, wenn ein Leistungsanstieg von zumindest 6 dB im Vergleich zu der Leistung des Pilotkanals vorhanden ist.

13. Verfahren nach Anspruch 12, welches folgende Schritte umfasst:
Bestimmen einer kumulativen Verteilungsfunktion der Ausgangsleistung für die Basisstation,
Festsetzen eines unterschiedlichen Schwellwerts für jeden der Verstärkerzweige (1, 2, 3) in Abhängigkeit von unterschiedlichen Werten der Verkehrslast in der kumulativen Verteilungsfunktion.

## Revendications

1. Station de base destinée à un système ou réseau de télécommunications sans fil comprenant :
un agencement d'amplificateurs (10) destiné à amplifier des signaux transmis par la station de base, dans laquelle
ledit agencement d'amplificateurs (10) comprend deux ou plusieurs branches d'amplificateurs parallèles, où une première branche d'amplificateur (1) est activée pour un canal pilote, lorsque aucun trafic ou un faible trafic existe et grâce à quoi une seconde branche d'amplificateur (2) est activée lorsque le trafic est en augmentation.

2. Station de base selon la revendication 1, dans laquelle au moins certaines, de préférence la totalité, des branches d'amplificateurs (1, 2, 3) procurent une puissance de sortie maximum différente.

3. Station de base selon l'une des revendications précédentes, comprenant un contrôleur d'amplificateur (5) qui commande lesdites branches d'amplificateurs (1, 2, 3) et/ou qui active et/ou désactive séparément lesdites branches d'amplificateurs (1, 2, 3).

4. Station de base selon la revendication précédente 3, dans laquelle ledit contrôleur d'amplificateur (5) active et/ou désactive lesdites branches d'amplificateurs (1, 2, 3) en réponse à la puissance de transmission HF dudit agencement d'amplificateurs (10).

5. Station de base selon la revendication 3 ou 4, comprenant un capteur de puissance d'entrée déterminant la puissance d'entrée au niveau d'une entrée commune desdites branches d'amplificateurs et transmettant ladite puissance d'entrée audit contrôleur d'amplificateur (5), dans laquelle ledit contrôleur d'amplificateur (5) commande lesdites branches d'amplificateurs (1, 2, 3) en réponse à ladite puissance d'entrée.

6. Station de base selon l'une des revendications 3 à 5, dans laquelle, pour chaque branche d'amplificateur (1, 2, 3), un seuil de puissance prédéterminé est défini et dans laquelle lesdites branches d'amplificateurs (1, 2, 3) sont activées par le contrôleur d'amplificateur (5) lorsque le seuil de puissance associé à la branche d'amplificateur respective (1, 2, 3) est dépassé.

7. Station de base selon l'une des revendications précédentes, dans laquelle chacune desdites branches d'amplificateurs (1, 2, 3) comprend un amplificateur ou est constitué d'un amplificateur et/ou la puissance de sortie maximum desdites branches d'amplificateurs (1, 2, 3) ou des amplificateurs est essentiellement calibrée de façon logarithmique l'une par rapport à l'autre.

8. Station de base selon l'une des revendications précédentes, dans laquelle ledit agencement d'amplificateurs (10) comprend au moins :
une première branche d'amplificateur (1) ayant une puissance de sortie maximum inférieure à 30 % de la puissance de sortie maximum totale dudit agencement d'amplificateurs (10),
une seconde branche d'amplificateur (2) ayant une puissance de sortie maximum de 10 % à 50 % de la puissance de sortie maximum totale dudit agencement d'amplificateurs (10) et
une troisième branche d'amplificateur (3) ayant une puissance de sortie maximum supérieure à 30 % de la puissance de sortie maximum totale dudit agencement d'amplificateurs (10).

9. Station de base selon l'une des revendications 6 à 8, dans laquelle les seuils de puissance sont différents pour au moins certaines desdites branches d'amplificateurs (1, 2, 3) et/ou lesdites branches d'amplificateurs (1, 2, 3) sont ensuite activées par puissance croissante.

10. Station de base selon l'une des revendications précédentes, dans laquelle une troisième branche d'amplificateur (3) est activée lorsque le trafic augmente encore.

11. Agencement d'amplificateurs (10), conçu pour une station de base destinée à un système ou un réseau de télécommunications sans fil selon l'une des revendications précédentes, comprenant deux ou plusieurs branches d'amplificateurs parallèles (1, 2, 3).

12. Procédé de mise en oeuvre d'une station de base, dans lequel
un agencement d'amplificateurs (10) ayant au moins une première, une seconde et une troisième branches d'amplificateurs (1, 2, 3) est prévu,
ladite première branche d'amplificateur (1) présente un niveau de puissance de sortie maximum inférieur à celui de ladite seconde branche d'amplificateur (2) et ladite seconde branche d'amplificateur (2) présente un niveau de puissance de sortie maximum inférieur à celui de ladite troisième branche d'amplificateur (3),
ladite première branche d'amplificateur (1) est activée lorsqu'un canal pilote est présent,
ladite seconde branche d'amplificateur (2) est activée par un contrôleur (5), lorsqu'une augmentation de puissance par comparaison à la puissance du canal pilote de 1 dB à 9 dB est présente et
ledit troisième amplificateur (3) est activé par ledit contrôleur (5), lorsqu'une augmentation de puissance par comparaison à la puissance du canal pilote d'au moins 6 dB est présente.

13. Procédé selon la revendication 12, comprenant les étapes consistant à :
déterminer une fonction de distribution cumulative de la puissance de sortie pour la station de base,
régler un seuil différent pour chacune desdites branches d'amplificateurs (1, 2, 3) suivant des valeurs différentes de charge de trafic dans ladite fonction de distribution cumulative.
